Europäisches Patentamt

European Patent Office

Office européen des brevets

(11) Publication number: **0 345 759 B1**

(12) **EUROPEAN PATENT SPECIFICATION**

(45) Date of publication of patent specification: **05.01.94**  (51) Int. Cl.⁵: **G01R  33/032**

(21) Application number: **89110299.8**

(22) Date of filing: **07.06.89**

(54) **A magnetic field measurement apparatus.**

(30) Priority: **10.06.88 JP 144263/88**

(43) Date of publication of application:
**13.12.89 Bulletin  89/50**

(45) Publication of the grant of the patent:
**05.01.94 Bulletin  94/01**

(84) Designated Contracting States:
**DE FR GB**

(56) References cited:
**EP-A- 0 086 387**
**EP-A- 0 262 016**

**PATENT ABSTRACTS OF JAPAN, vol. 12, no.
349 (C-529), 20th September 1988; & JP-A-63
107 900**

**IEEE TRANSACTIONS ON MAGNETICS, vol.
MAG-23, no. 5, part II of two parts, Septem-
ber 1987, pages 3479-3481, IEEE, New York,
US; K. MATSUDA et al.: "Bi-substituted rare-
earth iron garnet composite film with tem-
perature independent faraday rotation for
optical isolators"**

(73) Proprietor: **MATSUSHITA ELECTRIC INDUSTRI-
AL CO., LTD.**

1006, Oaza Kadoma
Kadoma-shi, Osaka(JP)

Proprietor: **THE KANSAI ELECTRIC POWER
CO., INC.**
3-22, Nakanoshima-3-chome
Kita-ku
Osaka-shi, Osaka 530(JP)

(72) Inventor: **Kamada, Osamu**
1658-285, Kitatawara-cho
Ikoma-shi Nara-ken(JP)
Inventor: **Minemoto, Hisashi**
1-2, Nabeshima
Momoyama-cho
Fushimi-ku
Kyoto-shi Kyoto(JP)
Inventor: **Toda, Kazurou**
1-1-31-518, Kitanakaburi
Hirakata-shi Osaka(JP)
Inventor: **Ishiko, Daisuke**
1-2-5, Yamanoue
Hirakata-shi Osaka(JP)

Rank Xerox (UK) Business Services
(3.10/3.9/3.3.3)

Inventor: **Ishizuka, Satoshi**
**77-16, Suyama-cho**
**Hirakata-shi Osaka(JP)**
Inventor: **Miura, Akihiro**
**3-11-11, Nishiakashi-cho**
**Akashi-shi Hyogo-ken(JP)**


(74) Representative: **Schwabe - Sandmair - Marx**
**Stuntzstrasse 16**
**D-81677 München (DE)**

## Description

This invention relates to a magnetic field measurement apparatus for determining the intensity of magnetic fields, in which Faraday rotation is observed using a magneto-optic element, according to the preamble of claim 1.

In recent years, as an optical method for determining the intensity of magnetic fields, the use of the Faraday effect has been proposed by, for example, Kyuma et al., IEEE, QE-18, 1619 (1982).

Methods for measuring the magnetic field intensity around a conductor through which current flows to thereby detect the current, in particular, are advantageous in that an excellent insulation can be attained because of the use of light as a medium, and electromagnetic induction noise immunity, so that the said methods can be applied to the disposition of power transmission.

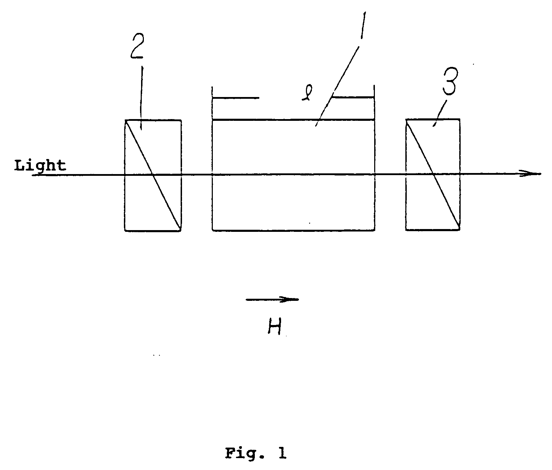

Figure 1 shows the principle of the method of measuring a magnetic field using the Faraday effect, in which a magneto-optic element 1 is placed in a magnetic field H. The linearly polarized light by a polarizer 2 is passed through the magneto-optic element 1. The polarization plane of light is rotated by an angle proportional to the magnetic field intensity H due to the Faraday effect. The polarized light rotated by the Faraday effect passes through an analyzer 3 which has a direction of polarization different from that of the polarizer 2 by 45°, and the angle of rotation, $\theta$, is converted to the change in the optical power. Optical output power in this case is given by the following equation.

$$Pout = K(1 + sin2\theta) \qquad (1)$$

$$\theta = CH\ell$$

wherein Pout denotes the optical output power, K a proportional constant, $\theta$ the Faraday rotation angle (degree), and C the sensitivity constant in unit of degrees/cm $x(1/4\pi x10^3 A/m(Oe))$ representing the sensitivity of the magneto-optic element.

Applications of magnetic field measurement apparatuses based on this principle have been proposed such as that which detects zero-phase current to determine the occurrence of accidents by feeding signals from magnetic field measuring instruments arranged at multiple points to an arithmetic operation unit where the waveforms are added or subtracted to generate reference signals.

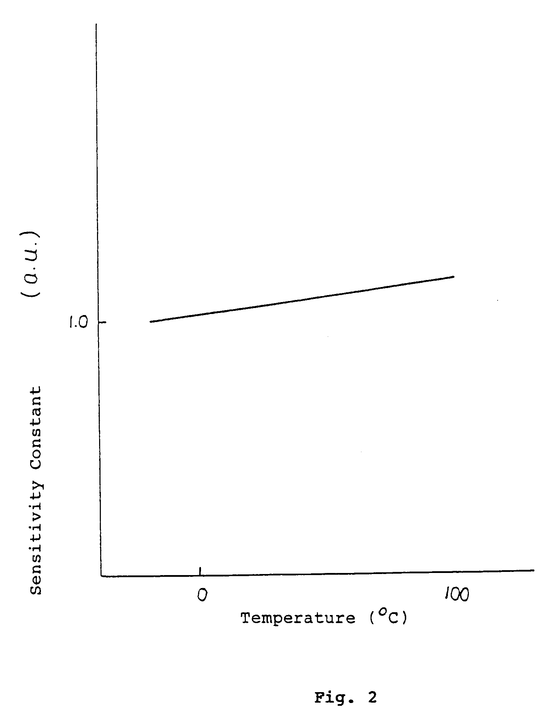

A typical magneto-optic element used in such a magnetic field measurement apparatus is YIG crystal which is represented by a general formula $Y_3Fe_5O_{12}$.However, as shown in Figure 2, the sensitivity constant C of YIG changes greatly with temperature, showing an increase as large as 16% over a temperature ranging from -20°C to 120°C around the working temperature, resulting in practical problem of great deviation in the measurement accuracy with the change of the ambient temperature. To eliminate this problem, a rare-earth iron garnet crystal, represented by a general formula $Tb_xY_{3-x}Fe_5O_{12}$ with x limited as $0.3 \leq x \leq 0.9$, is used for a magneto-optic element. An apparatus which uses this magneto-optic element has a remarkably improved measuring-accuracy of which a variation with temperature is ±1% over a temperature ranging from -25°C to 120°C.

On the other hand, a rare-earth iron garnet crystal substituted with Bi has a large Faraday effect and, when used for a magneto-optic element, improves the sensitivity of the magnetic field measurement apparatus. At present, however, the Bi-substituted rare-earth iron garnet crystal with the sensitivity constant of no temperature - dependence which has good characteristics in practical application has not yet been available.

Because magneto-optic elements with a length of about 2mm are required, rare-earth iron garnet crystals such as YIG which does not include Bi are made by the Flux method or FZ method, which makes the manufacturing period time long, causing a disadvantage in mass production of the measurement apparatus. Moreover, a magnetic field measurement apparatus utilizing as a magneto-optical element such rare-earth iron garnet crystals which do no include Bi must be provided with expensive light source and photo-detector designed for the 1.3 $\mu$m band, which makes the magnetic field measurement apparatus expensive.

From EP-A-0 086 387 an apparatus including the features listed in the preamble of claim 1 is known, showing at least some of the above disadvantages of the prior art discussed above.

The magnetic field measurement apparatus of this invention according to the preamble of claim 1, which overcomes the above-discussed and numerous other disadvantages and deficiencies of the prior art, comprises:

said magneto-optic element made of Bi-substituted rare-earth iron garnet crystal which is represented by a general formula $Bi_xGd_yY_{3-(x+y)}Fe_5O_{12}$ ($1.0 \leq x \leq 1.4$; $0.1 \leq y \leq 0.7$).

In a preferred embodiment, the magnetic field measurement apparatus comprises a plurality of magneto-optic transducers in the same number as that of the magnetic fields to be measured a plurality of light generating means to supply light to the light transmitting paths, a plurality of light detecting means that convert the optical output power into electric signals in the same number as that of the magnetic fields to be measured, and a signal processing circuit that adds and subtracts the electric signals received from each of the detecting means, wherein the magneto-optic transducers are placed into the magnetic fields to be measured to thereby determine the intensity of each of the magnetic fields.

In a preferred embodiment, the magneto-optic element is made of a crystal that is epitaxially grown on a Ca-Mg-Zr substituted $Gd_3Ga_5O_{12}$ or $Nd_3Ga_5O_{12}$ substrate.

In a preferred embodiment, the spectrum band of the light generating means has a peak at a wavelength in the range of 0.7 $\mu$m to 0.9 $\mu$m.

Thus, the invention described herein makes possible the objectives of (1) providing a magnetic field measurement apparatus with high sensitivity and high accuracy in which a Bi-substituted rare-earth iron garnet crystal with a high sensitivity constant that does not substantially vary depending upon temperatures is used for a magneto-optic element; and (2) providing a magnetic field measurement apparatus for which a magneto-optic element is formed by liquid phase epitaxy, and inexpensive light source and photodetector for the 0.8 $\mu$m band are used, thereby attaining mass production of the said magnetic field measurement apparatus at low costs.

This invention may be better understood and its numerous objects and advantages will become apparent to those skilled in the art by reference to the accompanying drawings as follows:

Figure 1 is a schematic diagram showing the principle of method of measuring the intensity of a magnetic field by the use of the Faraday effect.

Figure 2 is of a graph showing the variation of sensitivity constant of YIG with temperature.

Figure 3 is of a graph showing the dependence of the Gd concentration on the variation in the sensitivity constant of $Bi_xGd_yY_{3-(x+y)}Fe_5O_{12}$ with temperature.

Figure 4 is of a graph showing the Faraday effect of rare-earth iron garnet crystals.

Figure 5 is of a graph showing the variation in the Faraday rotation angle $\theta_F$ of $Bi_xGd_yY_{3-(x+y)}Fe_5O_{12}$.

Figure 6 is of a graph showing the change in the saturation magnetization Ms of $Bi_xGd_yY_{3-(x+y)}Fe_5O_{12}$ with temperature.

Figure 7 is of a graph showing the change in the sensitivity constant of $Bi_xGd_yY_{3-(x+y)}Fe_5O_{12}$ with temperature.

Figure 8 is a schematic diagram showing a magnetic field measurement apparatus of this invention which incorporates a magneto-optic transducer.

Figure 9 is of a graph showing the dependence of the measuring accuracy of the magnetic field measurement apparatus of Figure 8 on temperatures.

Figure 10 is a schematic diagram showing another magnetic field measurement apparatus of this invention which incorporates three magneto-optic transducers and an electric circuit for arithmetic operation.

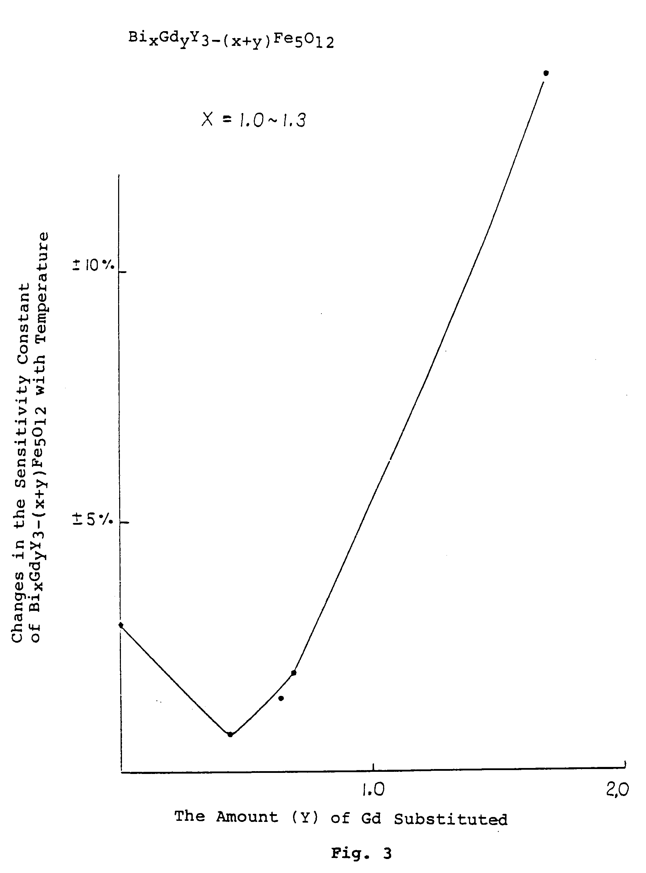

The magneto-optic element used in this invention is formed by a material that is represented by a general formula $Bi_xGd_yY_{3-(x+y)}Fe_5O_{12}$. The deviation of the sensitivity constant of this crystal with temperature is shown in Figure 3. When the value of y is in the range of 0.1 to 0.7 (i.e., $0.1 \leq y \leq 0.7$), the change is within ±1% over a temperature ranging from -20°C to 80°C. Especially, with $Bi_{1.3}Gd_{0.43}Y_{1.27}Fe_5O_{12}$, it exhibits the excellent characteristics with a temperature-dependence of as low as ±0.5%. The reasons therefor are as follows.

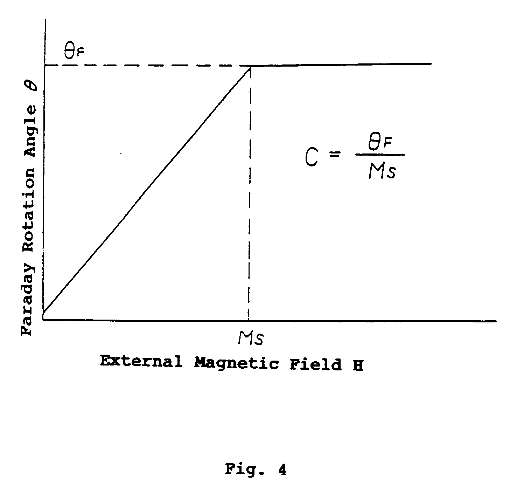

Rare-earth iron garnet crystals are a ferrimagnetic material and the Faraday effect of which saturates at a specified magnetic field intensity as shown in Figure 4. For the measurement of the magnetic field, a part of the characteristic curve of Figure 4 which shows linear change in response to an external magnetic field is used. In this case, the angle of Faraday rotation, $\theta$ caused by the external magnetic field is given as follows.

$$\theta = \theta_F (H/Ms)\ell \qquad (2)$$

where in $\theta_F$ denotes the specific Faraday rotation angle, Ms the saturation magnetization, and $\ell$ the length of crystal.

Accordingly, the sensitivity constant C and its temperature-dependence are defined as

$$C(T) = \theta_F(T)/Ms(T) \qquad (3)$$

As can be seen from equation (3), the dependence of the sensitivity constant on temperature is determined by the changes of both $\theta_F$ and Ms with temperature.

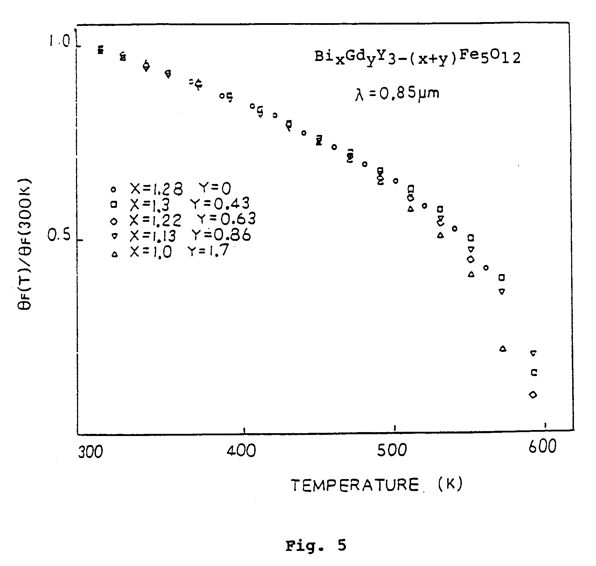

Figure 5 shows the change in $\theta_F$ of $Bi_xGd_yY_{3-(x+y)}Fe_5O_{12}$ with temperature. The measurements are normalized to $\theta_F$ at room temperature. The change of $\theta_F$ with temperature is insensitive to the amount y of Gd. This is because it is determined by x, the amount of substitution with Bi (x = 1.0 - 1.3 in this case).

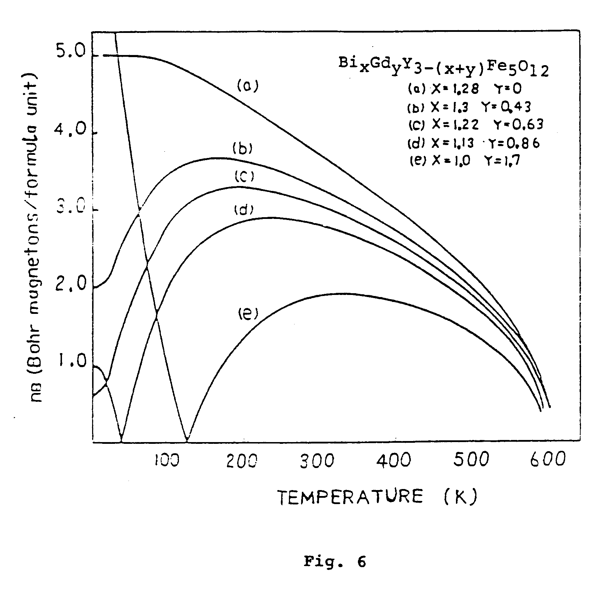

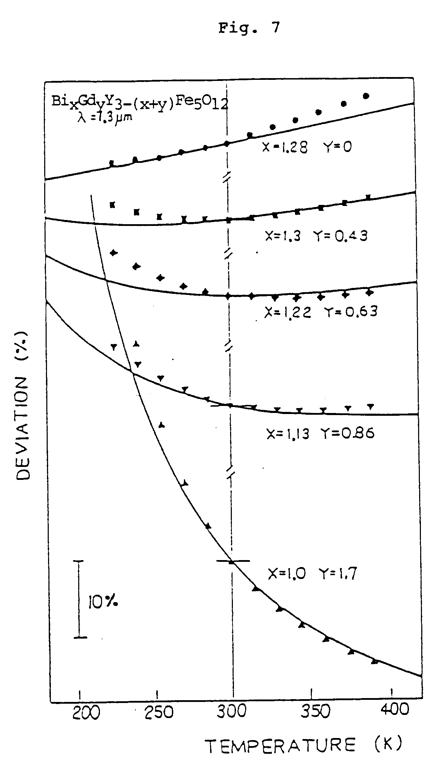

Figure 6 shows the change in Ms of $Bi_xGd_yY_{3-(x+y)}Fe_5O_{12}$ with temperature. The change in Ms with temperature around room temperature is decreased with an increase in the quantity y of Gd. As a result, the temperature-dependence of the sensitivity constant of materials belonging to the $Bi_xY_{3-y}Fe_5O_{12}$ group is improved by the addition of Gd. The result is shown in Figure 7. As also shown in Figure 3, $Bi_{1.3}Gd_{0.43}Y_{1.27}Fe_5O_{12}$ shows good temperature-dependence, which is within ±0.5%. These crystals have been grown on a Ca-Mg-Zr substituted $Gd_3Ga_5O_{12}$ substrate by means of liquid phase epitaxy that has good performance in means production. It has a sensitivity constant C that is $1.4°/cm•(1/4\pi x10^3 A/m(Oe))$ ($\lambda$ = 1.3 $\mu$m) or $5.0°/cm•(1/4\pi x10^3 A/m(Oe))$ ($\lambda$ = 0.85 $\mu$m), both of which are greater than that of a conventional YIG crystal. The sensitivity thereof is further improved by using a light source with shorter wavelengths, such as that in the case of $\lambda$ = 0.85 $\mu$m. Consequently, a magnetic field measurement apparatus that has high sensitivity, high temperature stability and good mass-production performance can be manufactured by using the magneto-optic element.

Example 1

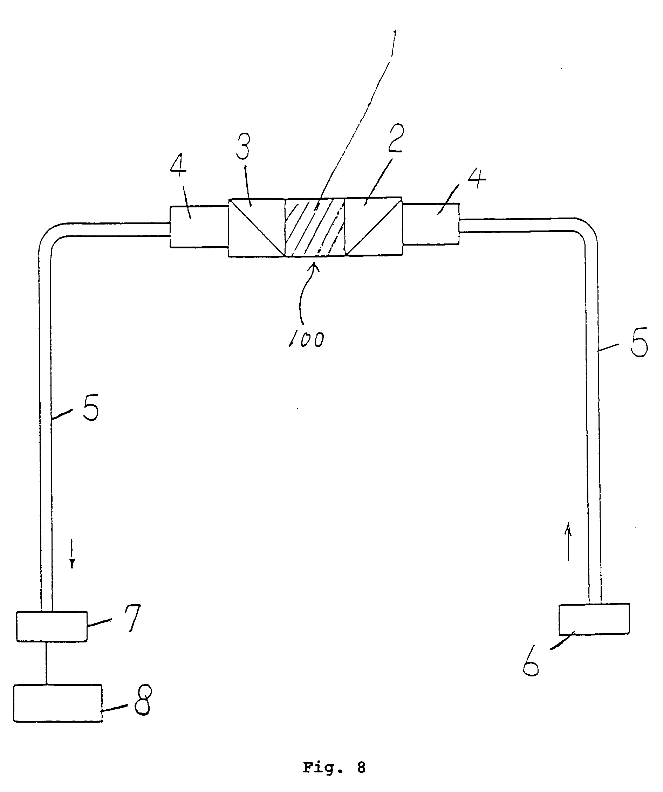

Figure 8 shows a magnetic field measurement of this invention, which comprises a magneto-optic transducer 100 that has a polarizer 2, an analyzer 3, and a magneto-optic element 1 made of Bi-substituted rare-earth iron garnet crystal which is represented by a general formula $Bi_xGd_yY_{3-(x+y)}Fe_5O_{12}$ ($1.0 \leq x \leq 1.4$; $0.1 \leq y \leq 0.7$) and placed between the polarizer and the analyzer which have polarization directions different from each other;

light transmission paths 5 that are provided on both sides of the magneto-optic transducer 100;

a light generating means 6 that supplies light to the light transmission path 5;

a light detecting means 7 that detects the optical output power generated by the incident light that has passed through the magneto-optic transducer 100 so as to convert the optical output power into electric signals; and

an electric circuit 8 that processes the electric signals fed from the light detecting means 7, wherein the magneto-optic transducer 100 is placed into the magnetic field to be measured to thereby determine the intensity of the magnetic field. The magneto-optic element 1 is made by the epitaxial growth of $Bi_{1.3}Gd_{0.43}Y_{1.27}Fe_5O_{12}$ which is 90 $\mu$m thick on a Ca-Mg-Zr substituted $Gd_3Ga_5O_{12}$ substrate. The polarizer 2 is provided on an end of the magneto-optic element 1. The analyzer 3 is provided on another end of the magneto-optic element 1 in such a configuration so the direction of polarization is inclined by 45° relative to the polarizer 2. For the polarizer 2 and the analyzer 3, a Glan-Thompson prism or a polarized beam splitter is used. A magneto-optic transducer 100, which comprises the magneto-optic element 1, the polarizer 2 and the analyzer 3, is placed in a magnetic field (H) to be measured. A lens 4 collimates the light incident upon the magneto-optic transducer 100 or the light passed through the magneto-optic transducer 100. The light transmission path 5 is formed by an optical fiber. The light generating mean 6 is constituted by a light emitting diode or laser diode that generates light with the 0.8 $\mu$m or 1.3 $\mu$m wavelength band. A light emitting diode which has a spectrum band with a peak at a wavelength $\lambda$ of 0.85 $\mu$m is used in this example. The detecting means 7 detects light which has passed through the element 1 and converts it to an electric signal. Although materials such as Ge-PD, Si-PIN-PD, etc., are usually used to make the detecting means 7, Si-PIN-PD is used in this example because a light emitting diode of 0.85 $\mu$m wavelength was used herein.

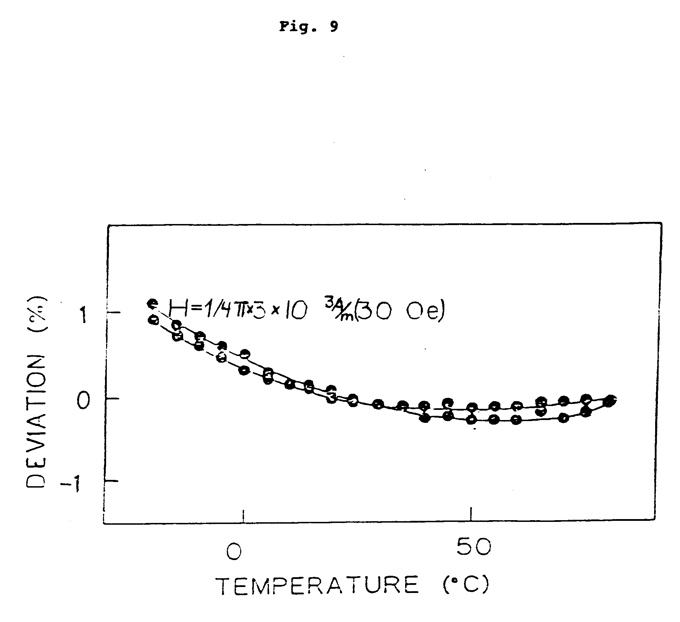

The intensity of a magnetic field, 150 $(1/4\pi x10^3)A/m$ (150 Oe) or less, was measured with such a magnetic field measurement apparatus, and measurement accuracy within ±1% was achieved over temperatures ranging from -20 to 80°C. Figure 9 shows the ambient temperature-dependence of the measurement error for magnetic field of 30 $(1/4\pi x10^3)A/m$ (30 Oe) generated by a constant alternate current. The variation is limited within ±0.5% with the change of the ambient temperature from -20 to 80°C.

Example 2

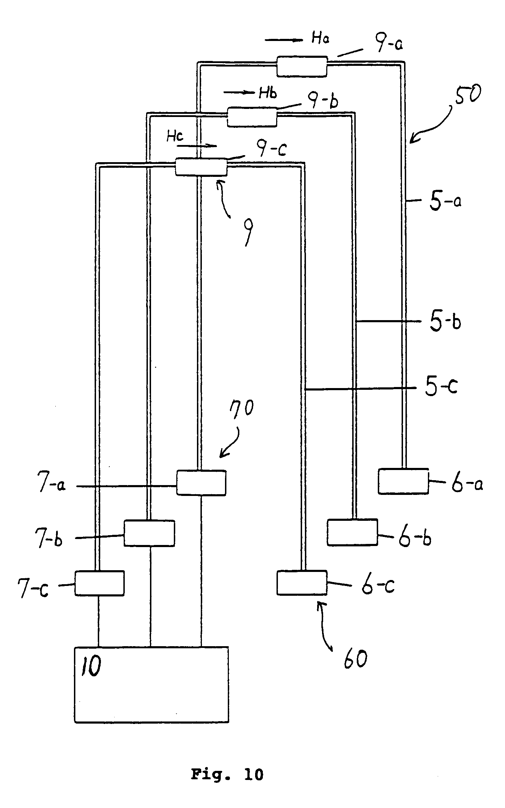

Figure 10 shows another magnetic field measurement apparatus of this invention, which comprises a magneto-optic transducer 9 that is composed of three magneto-optic transducer elements 9-a, 9-b, and 9-c each of which is the same as the magneto-optic transducer 100 (Figure 8) of Example 1, light transmission paths 50 that are composed of three pair of light transmission path elements 5-a, 5-b, and 5-c, each pair of which are the same as the light transmission paths 5 (Figure 8) of Example 1, a light generating means 60 that is composed of three light generating means elements 6-a, 6-b, and 6-c, each of which is the same as the light generating means 6 (Figure 8) of Example 1, and a light detecting means 70 that is composed of three light detecting means elements 7-a, 7-b, and 7-c, each of which is the same as the light detecting means 7 (Figure 8) of Example 1. This magnetic field measurement apparatus further comprises an arithmetic operation processing circuit 10, for the processing of electric signals from the light detecting means 70, which is used herein instead of the electric circuit 8 (Figure 8) of Example 1. By the use of this apparatus, the addition and subtraction of the measurements of the intensities of three different magnetic fields Ha, Hb and Hc were obtained with great accuracy.

As will be clear from the above description, the magnetic field measurement apparatus of this invention is capable of measuring a magnetic field intensity with high sensitivity and high accuracy independent of the changes in the ambient temperature, providing great advantages in the industrial applications.

## Claims

1. A magnetic field measurement apparatus comprising a magneto-optic transducer (100) that has a polarizer (2), an analyzer (3), and a magneto-optic element (1) made of Bi-substituted rare-earth iron garnet crystal and placed between the polarizer (2) and the analyzer (3) which have polarization directions different from each other; light transmission paths (5) that are provided on both sides of the magneto-optic transducer (100); a light generating means (6) that supplies light to the light transmitting path (5); a light detecting means (7) that detects the optical output power generated by the incident light that has passed through the magneto-optic transducer (100) so as to convert the optical output power into electric signals; and an electric circuit (8) that processes the electric signals fed from the light detecting means (7), wherein the magneto-optic transducer (100) is placed into the magnetic field to be measured to thereby determine the intensity of the magnetic field, **characterized** in that said magneto-optic element (1) is represented by a general formula $Bi_xGd_yY_{3-(x+y)}Fe_5O_{12}$ ($1.0 \leq x \leq 1.4$; $0.1 \leq y \leq 0.7$).

2. An apparatus according to claim 1, **characterized** by a plurality of magneto-optic transducers (100; 9-a, 9-b, 9-c) in the same number as that of the magnetic fields to be measured, a plurality of light generating means (60; 6-a, 6-b, 6-c) to supply light to the light transmitting paths (50; 5-a, 5-b, 5-c), a plurality of light detecting means (70; 7-a, 7-b, 7-c) to convert the optical output power into electric signals in the same number as that of the magnetic fields to be measured, and a signal processing circuit (10) that adds and subtracts the electric signals received from each of the detecting means (70; 7-a, 7-b, 7-c), wherein the magneto-optic transducers (100; 9-a, 9-b, 9-c) are placed into the magnetic fields to be measured to thereby determine the intensity of each of the magnetic fields.

3. An apparatus according to one of claims 1 or 2, **characterized** in that said magneto-optic element (1) is made of a crystal that is epitaxially grown on a Ca-Mg-Zr substituted $Gd_3Ga_5O_{12}$ or $Nd_3Ga_5O_{12}$ substrate.

4. An apparatus according to one of claims 1 to 3, wherein the spectrum band of said light generating means (6) has a peak at a wavelength in the range of 0.7 $\mu$m to 0.9 $\mu$m.

## Patentansprüche

1. Vorrichtung zur Messung eines Magnetfeldes mit einem magneto-optischen Meßwertaufnehmer (100), der einen Polarisator (2), einen Analysator (3) und ein magneto-optisches Element (1) aufweist, das aus einem Bi-substituierten Seltenerd-Eisen-Granatkristall hergestellt und zwischen dem Polarisator (2) und dem Analysator (3) angeordnet ist, welche voneinander unterschiedliche Polarisationsrichtungen haben; mit Lichtübertragungswegen (5), die auf beiden Seiten des magneto-optischen Meßwertaufnehmers (100) vorgesehen sind; mit einer lichterzeugenden Einrichtung (6), die dem Lichtübertragungsweg (5) Licht zuführt; mit einer lichtdetektierenden Einrichtung (7), die die optische Ausgangsleistung feststellt, die durch das einfallende Licht erzeugt wird, das den magneto-optischen Meßwertaufnehmer (100) passiert hat, um so die optische Ausgangsleistung in elektrische Signale umzusetzen; und mit einer elektrischen Schaltung (8), die die von der lichtdetektierenden Einrichtung (7) eingespeisten elektrischen Signale verarbeitet, wobei der magneto-optische Meßwertaufnehmer (100) in dem magnetischen Feld, das gemessen werden soll, angeordnet ist, um dadurch die Intensität des Magnetfeldes zu bestimmen, dadurch **gekennzeichnet**, daß das magneto-optische Element (1) durch eine allgemeine Formel $Bi_xGd_yY_{3-(x+y)}Fe_5O_{12}$ ($1,0 \leq x \leq 1,4$; $0,1 \leq y \leq 0,7$) dargestellt wird.

2. Vorrichtung nach Anspruch 1, **gekennzeichnet** durch mehrere magneto-optische Meßwertaufnehmer (100; 9-a, 9-b, 9-c) in der gleichen Anzahl wie die zu messenden Magnetfelder, durch mehrere lichterzeugende Einrichtungen (60; 6-a, 6-b, 6-c), um den Lichtübertragungswegen (50; 5-a, 5-b, 5-c) Licht zuzuführen, durch mehrere lichtdetektierende Einrichtungen (70; 7-a, 7-b, 7-c), um die optische Ausgangsleistung in elektrische Signale in der gleichen Anzahl wie die der zu messenden Magnetfelder umzusetzen, und durch eine signalverarbeitende Schaltung (10), die die von jeder der Detektionseinrichtungen (70; 7-a, 7-b, 7-c) empfangenen elektrischen Signale addiert und subtrahiert, wobei die magneto-optischen Meßwertnehmer (100; 9-a, 9-b, 9-c) in den zu messenden Magnetfeldern angeordnet sind, um dadurch die Intensität von jedem der Magnetfelder zu bestimmen.

**3.** Vorrichtung nach einem der Ansprüche 1 oder 2, dadurch **gekennzeichnet**, daß das magneto-optische Element (1) aus einem Kristall hergestellt ist, der epitaktisch auf einem Ca-Mg-Zr-substituierten $Gd_3Ga_5O_{12}$- oder $Nd_3Ga_5O_{12}$-Substrat aufgewachsen ist.

**4.** Vorrichtung nach einem der Ansprüche 1 bis 3, wobei das Spektralband der lichterzeugenden Einrichtung (6) einen Peak bzw. ein Maximum bei einer Wellenlänge im Bereich von 0,7 $\mu$m bis 0,9 $\mu$m hat.

**Revendications**

**1.** Appareil de mesure de champ magnétique comprenant un transducteur magnéto-optique (100), qui a un polariseur (2), un analyseur (3), et un élément magnéto-optique (1) fait d'un cristal de grenat de terres rares et de fer à substitution de Bi, placé entre le polariseur (2) et l'analyseur (3), qui ont des directions de polarisation différentes l'un par rapport à l'autre ; des chemins de transmission de lumière (5), qui sont prévus des deux côtés du transducteur magnéto-optique (100) ; un moyen émetteur de lumière (6), qui fournit de la lumière au chemin de transmission de lumière (5) ; un moyen photodétecteur (7), qui détecte la puissance de sortie optique produite par la lumière incidente qui a traversé le transducteur magnéto-optique (100), de manière à convertir la puissance de sortie optique en signaux électriques ; et un circuit électrique (8), qui traite les signaux électriques venant du moyen photodétecteur (7), dans lequel le transducteur magnéto-optique (100) est placé dans le champ magnétique à mesurer pour ainsi déterminer l'intensité du champ électrique, caractérisé en ce que ledit élément magnéto-optique (1) est représenté par une formule générale $Bi_xGd_yY_{3-(x+y)}Fe_5O_{12}$ (1,0 ≤ x ≤ 1,4 ; 0,1 ≤ y ≤ 0,7).

**2.** Appareil selon la revendication 1, caractérisé par une pluralité de transducteurs magnéto-optiques (100, 9-a, 9-b, 9-c), dont le nombre correspond à celui des champs magnétiques à mesurer, une pluralité de moyens émetteurs de lumière (60 ; 6-a, 6-b, 6-c) pour fournir de la lumière aux chemins de transmission de lumière (50 ; 5-a, 5-b, 5-c) ; une pluralité de moyens photodétecteurs (70 ; 7-a, 7-b, 7-c) pour convertir la puissance optique de sortie en signaux électriques, leur nombre correspondant à celui des champs magnétiques à mesurer, et un circuit de traitement de signaux (10) qui additionne et soustrait les signaux électriques provenant de chacun des moyens détecteurs (70 ; 7-a, 7-b, 7-c), dans lequel les transducteurs magnéto-optiques (100 ; 9-a, 9-b, 9-c) sont placés dans les champs magnétiques à mesurer pour ainsi déterminer l'intensité de chacun des champs magnétiques.

**3.** Appareil selon l'une des revendications 1 ou 2, caractérisé en ce que ledit élément magnéto-optique (1) est fait d'un cristal formé par épitaxie sur un substrat de $Gd_3Ga_5O_{12}$ ou $Nd_3Ga_5O_{12}$ à substitution de Ca-Mg-Zr.

**4.** Appareil selon l'une des revendications 1 à 3, dans lequel la bande du spectre dudit moyen émetteur de lumière (6) a un pic à une longueur d'onde dans la plage de 0,7 $\mu$m à 0,9 $\mu$m.

Fig. 1

Fig. 2

$Bi_xGd_yY_{3-(x+y)}Fe_5O_{12}$

$X = 1.0 \sim 1.3$

Fig. 3

Fig. 4

Fig. 5

Fig. 6

Fig. 7

Fig. 8

Fig. 9

**Fig. 10**